# FASCICULE DE BREVET EUROPEEN

(11) **EP 1 735 404 B1**
(45) Date de publication et mention de la délivrance du brevet: **11.08.2010**
(21) Numéro de dépôt: 05753855.5
(22) Date de dépôt: 06.04.2005
(51) Int. Cl.: C09K 11/59

(54) **DIODE ELECTROLUMINESCENTE EMETTANT UNE LUMIERE BLANCHE**
WEISSES LICHT EMITTIERENDE DIODE
WHITE LIGHT EMITTING DIODE

(30) Priorité: 16.04.2004 FR 0404045
(43) Date de publication de la demande: 27.12.2006
(73) Titulaire: RHODIA CHIMIE, 92512 Boulogne Billancourt Cedex (FR)
(72) Inventeur: CEINTREY, Claude, F-78160 MARLY-LE-ROI (FR); WORTHAM, Etienne, F-77700 COUPVRAY (FR)
(74) Mandataire: Dubruc, Philippe
(86) Numéro de dépôt international: PCT/FR2005/000841
(87) Numéro de publication internationale: WO 2005/112135

(56) Documents cités:
- GB-A- 829 546
- US-A- 5 194 332
- US-A- 5 839 718
- PATENT ABSTRACTS OF JAPAN vol. 2000, no. 04, 31 août 2000 (2000-08-31) & JP 2000 017257 A (NICHIA CHEM IND LTD), 18 janvier 2000 (2000-01-18)
- PATENT ABSTRACTS OF JAPAN vol. 2002, no. 05, 3 mai 2002 (2002-05-03) & JP 2002 003837 A (MATSUSHITA ELECTRIC IND CO LTD), 9 janvier 2002 (2002-01-09)

## Description

La présente invention concerne une diode électroluminescente émettant une lumière blanche.

Les diodes électroluminescentes (DEL) sont des produits en plein développement actuellement. On cherche tout particulièrement à obtenir des DEL émettant dans le blanc. Il est nécessaire pour cela et pour avoir un bon rendu de couleur de mettre en oeuvre dans la fabrication de telles DEL une combinaison d'au moins trois luminophores émettant chacun dans une couleur d'émission primaire. Or, il est souhaitable d'utiliser le minimum possible de luminophores afin de faciliter la fabrication de ces DEL et/ou d'améliorer leurs propriétés.

US 5194332 décrit des luminophores dopés à l'europium de formule générale BaMg₂Si₂O₇ qui sont recuits en présence d'un flux. Ces luminophores sont utilisés en fait dans des lampes fluorescentes.

La présente invention répond à ce besoin.

Dans ce but, la diode électroluminescente selon l'invention, qui émet une lumière blanche, est caractérisée en ce qu'elle comprend:
- une source d'émission d'une radiation dans la gamme de longueur d'onde comprise entre 370 nm et 420 nm;
- un premier luminophore émettant une lumière bleue et une lumière rouge, de formule :

   Bci₃₍₁₋ₓ₎Eu₃ₓMg_{1-y}Mn_{y}Si₂O₈ (1)

   dans laquelle 0 < x ≤ 0,3 et 0 < y ≤ 0,3;
- un second luminophore émettant une lumière verte.

Selon un autre mode de réalisation de l'invention, la diode émettant dans le blanc est caractérisée en ce qu'elle comprend :
- une source d'émission d'une radiation dans la gamme de longueur d'onde comprise entre 370 nm et 420 nm;
- un luminophore de composition chimique suivante :

   Ba₃₍₁₋ₓ₎Eu₃ₓMg_{1-y}Mn_{y}Si₂O₈

   avec 0 < x ≤ 0,3 et 0 < y ≤ 0,3;
   ce luminophore se présentant sous la forme d'un mélange d'au moins des phases Ba₂SiO₄, Ba₂MgSi₂O₇ et Ba₃MgSi₂O₈.

Les DEL selon les différents modes de réalisation de l'invention ont l'avantage de ne comprendre qu'un nombre réduit de luminophores.

D'autres caractéristiques, détails et avantages de l'invention apparaîtront encore plus complètement à la lecture de la description qui va suivre et du dessin annexé dans lequel :
- la figure 1 est un graphe qui représente les spectres d'émission de deux luminophores selon l'invention pour une longueur d'onde d'excitation de 370 nm;
- la figure 2 est un graphe qui représente le spectre d'excitation d'un luminophore selon l'invention pour une longueur d'onde d'émission de 623 nm;
- la figure 3 est un graphe qui représente le spectre d'émision d'un luminophore selon l'invention pour une longueur d'onde d'excitation de 370 nm;
- la figure 4 est un graphe qui représente les spectres d'émission de trois luminophores selon l'invention pour une longueur d'onde d'excitation de 370 nm.

Par terre rare on entend les éléments du groupe constitué par le scandium, l'yttrium et les éléments de la classification périodique de numéro atomique compris inclusivement entre 57 et 71.

On précise pour la suite de la description que, sauf indication contraire, dans les fourchettes de valeurs qui sont données, les valeurs aux bornes sont incluses.

Dans le cas du premier mode de réalisation de l'invention, la DEL comprend trois éléments essentiels qui sont une source d'émission et deux luminophores.

Plus précisément, la source d'émission est une source capable d'émettre une radiation dont la longueur d'onde est comprise dans la gamme de 370 nm environ à 420 nm environ. Il s'agit en fait d'une radiation dans la gamme de l'ultra-violet proche visible. De telles sources sont bien connues dans la technique, ce peut être par exemple des semi-conducteurs du type InGaN, GaN ou AIGaN.

D'une manière connue en soi, cette source est munie de connections électriques pour être reliée à un circuit électrique. La radiation émise par la source va servir à exciter les luminophores de la DEL de l'invention.

Dans le cas du premier mode de réalisation, la DEL comprend un premier luminophore qui est capable d'émettre à la fois une lumière bleue et une lumière rouge. Ce luminophore répond à la formule (1) qui a été donnée plus haut.

Ce luminophore est un silicate de baryum et de magnésium, dopé avec de l'europium, qui peut être considéré en substitution partielle du baryum, et avec du manganèse, qui peut être considéré en substitution partielle du magnésium.

Lorsqu'il est soumis à une excitation UV, c'est à dire à un rayonnement dans une gamme de longueur d'onde comprise entre environ 370 nm et environ 420 nm, ce produit a pour propriété d'émettre notamment dans le rouge et aussi dans le bleu, c'est à dire dans une gamme de longueurs d'onde comprises entre 400 nm et 500 nm pour le bleu et entre 550 nm et 720 nm, plus particulièrement entre 550 nm et 700 nm, pour le rouge avec un bon rendement.

Plus particulièrement, le luminophore répond à la formule (1) précitée dans laquelle 0,0001 ≤ x ≤ 0,25 et 0,0001 ≤ y ≤ 0,25.

Encore plus particulièrement, le luminophore répond à la formule (1) précitée dans laquelle 0,01 ≤ x ≤ 0,25 et 0,01 ≤ y ≤ 0,25.

On peut noter qu'il est avantageux d'avoir une concentration en europium dans le composé d'au moins 0,01% pour obtenir une émission de meilleure intensité. Il est aussi avantageux d'avoir une concentration en europium et en manganèse d'au plus 25% afin de limiter au maximum des phénomènes d'auto-extinction gênants. Les pourcentages indiqués ci-dessus correspondent aux taux de substitution en mole des ions dopants Eu²⁺ et Mn² respectivement aux ions Ba²⁺ et Mg²⁺.

Selon une autre variante, le luminophore de formule (1) vérifie les valeurs de x et y suivantes : 0,01 ≤ x ≤ 0,03 et 0,04 ≤ y ≤ 0,06. Pour ces valeurs de x et de y l'intensité d'émission est la plus importante.

Selon encore une autre variante, le luminophore de formule (1) vérifie les valeurs de x et y suivantes : 0,01 ≤ x ≤ 0,02 et 0,05 ≤ y ≤ 0,1. Dans ce cas, les luminophores présentent pour chacune des couleurs bleu et rouge des intensités d'émission sensiblement identiques entre elles.

Selon une dernière variante, le luminophore de formule (1) vérifie les valeurs de x et y suivantes : 0,09 ≤ x ≤ 0,11 et 0,09 ≤ y ≤ 0,11. Dans ce cas, les luminophores présentent une intensité d'émission élevée pour la couleur rouge.

Enfin, dans le composé de formule (1), le baryum, le magnésium et le silicium peuvent être partiellement substitués par d'autres éléments que ceux qui ont été décrits plus haut. Ainsi, le baryum peut être partiellement substitué par du calcium et/ou du strontium dans une proportion qui peut aller jusqu'à environ 30%, cette proportion étant exprimée par le rapport atomique substituant/(susbtituant+baryum). Le magnésium peut être partiellement substitué par du zinc dans une proportion qui peut aller jusqu'à environ 30%, cette proportion étant aussi exprimée par le rapport atomique Zn/(Zn+Mg). Enfin, le silicium peut être partiellement substitué par du germanium, de l'aluminium et/ou du phosphore dans une proportion qui peut aller jusqu'à environ 10%, cette proportion étant exprimée par le rapport atomique substituant/(susbtituant+silicium).

Enfin, ce premier luminophore se présente sous une forme phasiquement pure. Le diagramme RX de ce produit ne fait apparaître en effet qu'une phase correspondant à la phase Ba₃MgSi₂O₈.

Le second luminophore de la DEL selon le premier mode de réalisation est un luminophore émettant une lumière verte. On entend par là une lumière dont la longueur d'onde est comprise entre environ 500 nm et environ 550 nm. Ce luminophore est capable d'émettre cette lumière lorsqu'il est soumis à la radiation émise par la source précitée.

Il existe plusieurs produit connus susceptibles d'être utilisés comme second luminophore de ce type pour la DEL selon l'invention.

Ainsi, ce second luminophore peut être choisi parmi les familles de produits ci-dessous :
- les sulfures de zinc ZnS dopés au cuivre ou dopés au cuivre et à l'aluminium;
- les silicates d'alcalino-terreux dopés à l'europium; on entend par là les produits du type MSi₂O₅ : Eu²⁺ ou M₂SiO₄: Eu²⁺, M étant un alcalino-terreux comme le baryum ou le strontium;
- les aluminates d'alcalino-terreux dopés à l'europium ou à l'europium en combinaison avec le manganèse comme les produits du type MAl₂O₄: Eu²⁺, M étant un alcalino-terreux comme le strontium, M₄Al₁₄O₂₅ : Eu²⁺, M étant un alcalino-terreux comme le strontium ou encore du type M_{0,82}Al₁₂O_{18,82} : Eu²⁺ ou M_{0,82}Al₁₂O_{18,82} Eu²⁺ Mn²⁺, M étant un alcalino-terreux comme le baryum;
- les borates de terre rare dopés au cérium et au terbium comme par exemple les produits de formule MBO₃ : (Ce³⁺, Tb³⁺), M étant au moins une terre rare comme Sc, Gd, Lu éventuellement combinée avec l'yttrium;
- les thiogallates, thioaluminates ou thioindates de zinc, de magnésium ou d'alcalino-terreux dopés à l'europium et/ou au manganèse ou encore dopés au cérium et au terbium; il peut s'agir ici de produits du type MN₂S₄ : dopants, M désignant au moins le zinc, le magnésium ou un alcalino-terreux comme par exemple Ca, Sr, Ba et N désignant au moins Al, Ga et In;
- les phosphates ou borophosphates d'alcafino-terreux dopés à l'europium ou dopés à l'europium et au terbium; on peut citer ici les produits de formule M₂P₂O₇: Eu²⁺, Tb³⁺) ou de formule M₆BP₅O₂₀ : Eu²⁺, formules dans lesquelles M est un alcalino-terreux comme le strontium par exemple;
- les silicates de terre rare dopés à l'europium et au terbium, comme les produits de formule M₂SiO₅. (Ce³⁺, Tb³⁺), M étant au moins une terre rare comme Y, Gd et Lu;
- les silicates d'yttrium et d'azote dopés à l'europium comme Y₅(SiO₄)₃N : Ce³⁺;
- les aluminates de magnésium et d'alcalino-terreux dopés à l'europium en combinaison avec le cérium et le terbium ou en combinaison avec du manganèse; on peut mentionner les produits du type MMgAl₁₀O₁₇ : dopant, M étant au moins un alcalino-terreux, par exemple une combinaison Ba, Sr;
- les chlorosilicates de magnésium et d'alcalino-terreux dopés à l'europium éventuellement en combinaison avec du manganèse, notamment un produit du type M₈Mg(SiO₄)Cl₂ : dopant(s), M étant un alcalino-terreux, par exemple le calcium.

D'une manière connue en soi, les produits mentionnés comme dopants dans les produits qui viennent d'être cités ci-dessus sont utilisés en combinaison avec la matrice pour lui donner les propriétés requises de luminescence.

Comme second luminophore préféré dans le cadre de la présente invention, on peut utiliser Ba₂SiO₄ dopé à l'europium, SrGa₂S₄ dopé à l'europium, le sulfure de zinc dopé au cuivre ou dopé au cuivre et à l'aluminium et SrAl₂O₄ dopé à l'europium.

On peut aussi utiliser à titre de second luminophore un composé à base d'au moins un élément A choisi parmi les alcalino-terreux, d'au moins un élément B choisi parmi l'aluminium, le gallium ou l'indium, de soufre et d'un dopant susceptible de conférer des propriétés de luminescence audit composé et qui se présente sous la forme d'un mélange d'une phase cristallographique majoritaire de type AB₂S₄ et d'une phase cristallographique de type B₂S₃. Un tel composé est décrit dans la demande de brevet WO 02/100976 à l'enseignement de laquelle on pourra se référer. L'élément B peut être plus particulièrement le gallium et l'élément A le strontium. Le dopant peut être choisi parmi le manganèse divalent, les terres rares divalentes et dans le groupe comprenant les terres rares trivalentes en combinaison avec un alcalin, le dopant pouvant être plus particulièrement l'europium Il, l'ytterbium en combinaison avec un alcalin.

Le luminophore de formule (1) utilisé pour l'invention se prépare généralement par une réaction à l'état solide à haute température.

Comme produit de départ, on peut utiliser directement les oxydes des métaux requis ou des composés organiques ou minéraux susceptibles de former ces oxydes par chauffage comme les carbonates, oxalates, hydroxydes, acétates, nitrates, borates desdits métaux.

On forme un mélange intime, notamment par broyage, aux concentrations appropriées de tous les produits de départ à l'état finement divisé.

On peut également envisager de préparer un mélange de départ par co-précipitation à partir de solutions des précurseurs des oxydes désirés, par exemple en milieu aqueux.

Le mélange des produits de départ est ensuite chauffé au moins une fois pendant une période comprise entre une heure et une centaine d'heures environ, à une température située entre environ 500°C et environ 1300°C; il est préférable d'effectuer le chauffage en présence d'un flux, par exemple du type NH₄Cl, et au moins en partie sous une atmosphère réductrice (hydrogène dans l'argon par exemple) pour porter totalement l'europium à l'état divalent.

Le second mode de réalisation de l'invention va maintenant être décrit.

La différence avec le premier mode est que la diode ne comprend plus qu'un seul luminophore. Il s'agit d'un produit qui répond à la composition chimique donnée plus haut. Cette composition correspond à la formule (1) donnée précédemment avec les valeurs précitées de x et de y. Toutes les valeurs plus particulières de x et de y qui ont été mentionnées plus haut ainsi que ce qui a été dit pour les possibles substitutions partielles du baryum, du magnésium et du silicium s'appliquent aussi ici pour ce luminophore. Mais, à la différence du luminophore du premier mode qui est phasiquement pur, celui-ci se présente sous la forme d'un mélange d'au moins trois phases. Il s'agit d'au moins des phases Ba₂SiO₄, Ba₂MgSi₂O₇ et Ba₃MgSi₂O₈. Une phase supplémentaire du type BaCO₃ peut éventuellement être présente. L'existence de ces phases est mise en évidence par l'analyse RX et les diagrammes qui en résultent.

Lorsqu'il est soumis à une excitation UV du même type qu'indiqué plus haut (comprise entre environ 370 nm et environ 420 nm), ce produit émet dans le rouge et dans le bleu mais aussi dans le vert (émission entre 500 nm et 550 nm). De ce fait, dans le cas de ce second mode de réalisation, la DEL de l'invention qui émet dans le blanc ne comprend toutefois qu'un luminophore unique.

Le luminophore du second mode de réalisation peut aussi être préparé par réaction solide/solide à haute température à partir des oxydes des métaux requis ou des composés organiques ou minéraux susceptibles de former ces oxydes par chauffage comme les carbonates, oxalates, hydroxydes, acétates, nitrates, borates desdits métaux.

On forme dans ce cas un mélange homogène aux concentrations appropriées de tous les produits de départ. Ce mélange se fait par simple désagglomération des poudres des produits de départ sans mettre en oeuvre un broyage. On procède ensuite à une calcination. Cette calcination peut se faire sans flux. Elle est réalisée de préférence au moins en partie sous une atmosphère réductrice (hydrogène dans l'argon par exemple) pour la raison donnée plus haut et à une température qui est d'environ au moins 500°C et d'au plus 1150°C de préférence.

Dans les deux modes de réalisations décrits il est préférable d'utiliser des luminophores dont les tailles sont d'au plus 20 µm et de préférence d'au plus 10µm et dont la taille moyenne peut être par exemple comprise entre 3 µm et 6 µm. Ces valeurs de taille sont celles déterminées par la technique de diffraction laser et en utilisant un granulomètre du type COULTER (associé à une sonde à ultrason de 450 W).

Dans les deux modes de réalisations décrits et d'une manière connue pour la fabrication d'une DEL, le ou les luminophores sont incorporés dans une matrice polymère, du type époxy par exemple, dans laquelle est insérée la source d'émission de radiation précitée, l'ensemble étant placé dans un boîtier.

Dans le cas du premier mode de réalisation, la colorimétrie blanche de la lumière émise par la DEL dépend de la nature des deux luminophores et de leurs proportions respectives. De manière connue, ces proportions peuvent être définies à partir de la détermination des rendements quantiques relatifs de chacun des luminophores.

L'invention concerne enfin un dispositif d'éclairage qui est caractérisé en ce qu'il comprend une diode du type décrit ci-dessus. De tels dispositifs, comme les lampes, sont bien connus et sont constitués par exemple d'une ou de plusieurs DEL, insérées par couches, dans des boîtiers dont une surface est transparente.

Des exemples vont maintenant être donnés.

### EXEMPLE 1

Cet exemple concerne un luminophore utilisable pour le premier mode de réalisation de l'invention et répondant à la composition Ba₃MgSi₂O₈: 2% Eu²⁺, 5% Mn²⁺ et correspondant à la formule Ba_{2,94}Eu_{0,06}Mg_{0,95}Mn_{0,05}Si₂O₈ (les pourcentages indiqués pour les ions dopants correspondent aux taux de substitution en mole des ions Eu²⁺ et Mn²⁺ respectivement aux ions Ba²⁺ et Mg²⁺). On procède par voie solide en mélangeant les oxydes BaCO₃, Eu₂O₃, (MgCO₃)₄Mg(OH)₂.5H₂O, MnCO₃ et SiO₂ dans des proportions stoechiométriques. 0,4 mole de NH₄Cl est ajoutée au mélange en tant que flux.

| Produits de départ | Quantités mises en oeuvre |
|---|---|
| BaCO₃ | 1,8629 g |
| Eu₂O₃ | 0,0339 g |
| (MgCO₃)₄Mg(OH)₂.5H₂O | 0,2963 g |
| MnCO₃ | 0,0185 g |
| SiO₂ | 0,3858 g |
| NH₄Cl | 0,0687 g |

Ces produits de départ sont mélangés de façon homogène par broyage; le mélange, placé dans un creuset, est introduit dans un four où il subit deux traitements thermiques. Un premier traitement thermique est effectué à 600 °C pendant 4 heures à l'air. Le mélange, de couleur grise, est alors broyé puis replacé au four dans un creuset en alumine. Après une purge de 4 heures du four avec un mélange Ar/H₂ 10 %, le mélange est chauffé 4 heures à 1200 °C dans cette atmosphère réductrice. Une rampe de montée et de descente en température de 360 °C/h est employée. Le produit obtenu se présente sous la forme d'une poudre blanche.

### EXEMPLE 2

Cet exemple concerne un luminophore utilisable pour le premier mode de réalisation de l'invention et répondant à la composition Ba₃MgSi₂O₈: 2% Eu²⁺, 20% Mn²⁺ et correspondant à la formule Ba_{2,94}Eu_{0,06}Mg_{0,8}Mn_{0,2}Si₂O₈. On procède comme dans l'exemple 1, par voie solide, en mélangeant les oxydes BaCO₃, Eu₂O₃, (MgCO₃)₄Mg(OH)₂.5H₂O, MnCO₃ et SiO₂ dans des proportions stoechiométriques, 0,4 mole de NH₄Cl est ajoutée au mélange en tant que flux.

| Produits de départ | Quantités mises en oeuvre |
|---|---|
| BaCO₃ | 1,8629 g |
| Eu₂O₃ | 0,0339 g |
| (MgCO₃)₄Mg(OH)₂.5H₂ | 0,2492 g |
| MnCO₃ | 0,0740 g |
| SiO₂ | 0,3858 g |
| NH₄Cl | 0,0687 g |

Le mode opératoire est ensuite identique à celui de l'exemple 1.

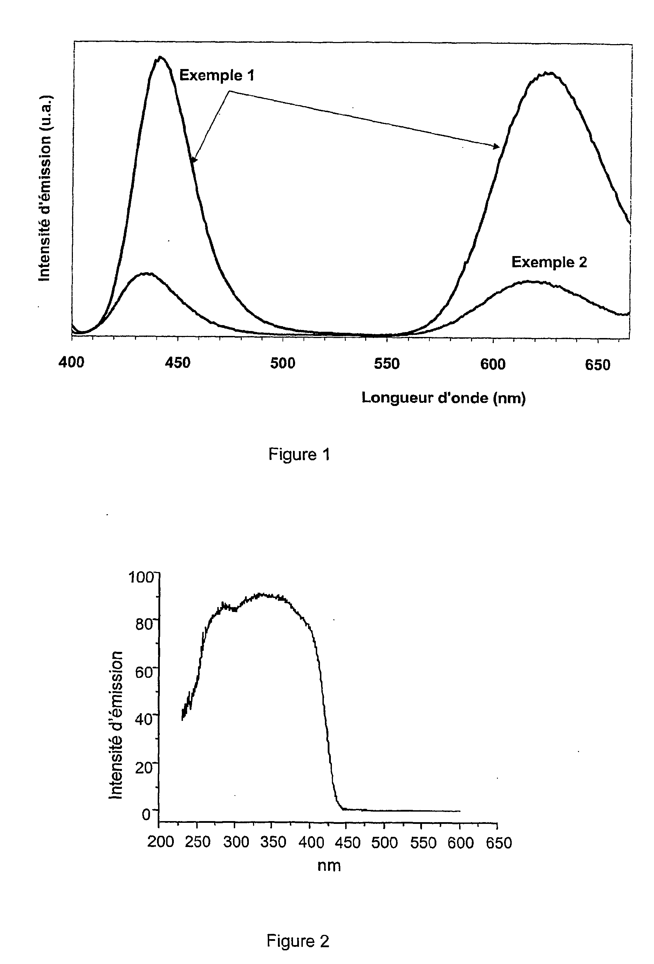

Les courbes de la figure 1 donnent, pour les composés ainsi obtenus, le spectre d'émission pour une longueur d'onde d'excitation de 370 nm. On voit donc qu'en réponse à une excitation dans le domaine des UV, les composés émettent dans le rouge (pic vers 625nm) et aussi dans le bleu (pic vers 440nm).

Le spectre d'excitation du composé de l'exemple 1, pour la longueur d'onde d'émission 623 nm, est représenté à la figure 2. Il apparaît de cette figure que le rendement maximum est atteint pour une longueur d'onde de 350nm. Entre 350nm et 400nm le rendement relatif varie entre 100% et 78%.

### EXEMPLE 3

On forme un mélange du luminophore de l'exemple 1 avec le composé de formule (Sr_{0,95}Eu_{0,05})Ga_{2,1}S₄ obtenu de la manière décrite dans l'exemple 1 de WO 02/100976, dans différentes proportions massiques. On donne ci-dessous les coordonnées trichromatiques des mélanges obtenus. Ces coordonnées sont calculées à partir du spectre d'émission des mélanges et selon la norme NF X 08-12 (Système x, y CIE 1931).

| | | |
|---|---|---|
| Luminophore ex.1 | 60% | 70% |
| (Sr_{0,95}EU_{0,05})Ga_{2,1}S₄ | 40% | 30% |
| Coordonnées trichromatiques | x = 0,341 | x = 0,352 |
| | y = 0,374 | y = 0,325 |

### EXEMPLE 4

Cet exemple concerne un luminophore utilisable pour le second mode de réalisation de l'invention.

Le composé préparé est identique à celui de l'exemple 1 pour sa formulation. On procède comme décrit dans l'exemple 1 en partant des mêmes produits de départ et dans les mêmes quantités. Toutefois, ces produits sont simplement mélangés et désaglomérés sans être broyés.

On procède ensuite à la calcination comme dans l'exemple 1.

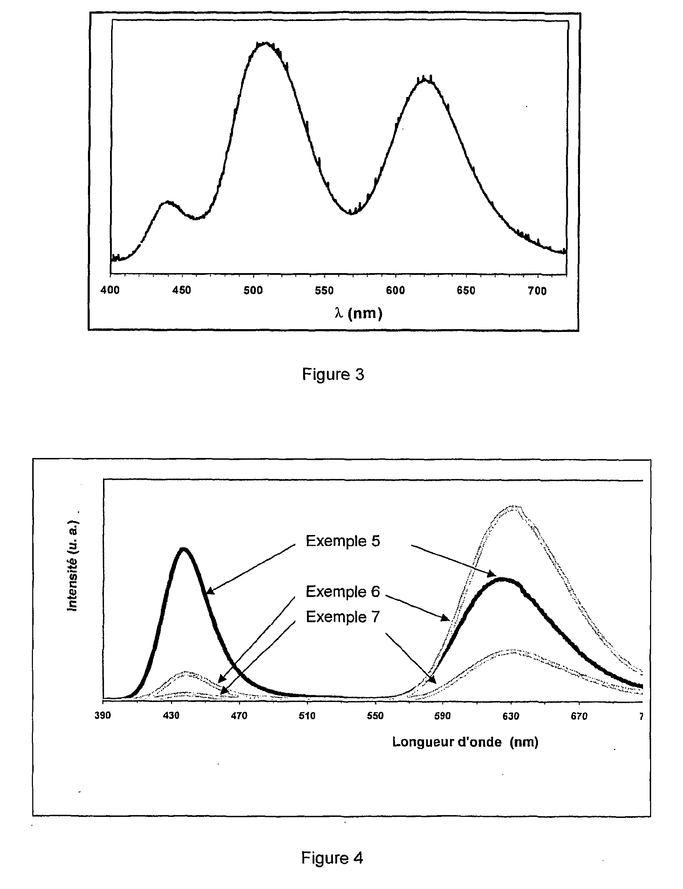

La figure 3 donne, pour le composés ainsi obtenu, le spectre d'émission pour une longueur d'onde d'excitation de 370 nm. On voit donc qu'en réponse à une excitation dans le domaine des UV, le composé émette dans le rouge (pic vers 625 nm), dans le bleu (pic vers 440 nm) et aussi dans le vert (pic vers 510 nm).

Les coordonnées trichromatiques du composé sont calculées à partir du spectre d'émission de la figure 3 et selon la norme précitée. Ces coordonnées sont x = 0,36 et y = 0,4.

### EXEMPLES 5 à 7

Ces exemples concernent des luminophores utilisables pour le premier mode de réalisation de l'invention.

Pour préparer les produits, on procède comme dans l'exemple 1 en mélangeant les produits de départ et en broyant pendant 30 minutes. Un premier traitement thermique est effectué à 950°C pendant 2 heures à l'air. On mélange en 30 minutes le produit issu de la calcination avec 1% en poids de NH₄Cl. Le mélange est chauffé ensuite 4 heures à 1200 °C dans une atmosphère réductrice constituée par un mélange Ar/H₂ à 5 % en H₂. A l'issue du traitement on broie légèrement le produit.

On donne ci-dessous dans le tableau 1 les quantités utilisées des produits de départ (en g.) et dans le tableau 2 les formules des luminophores obtenus.

**Tableau 1**

| Exemple | BaCO₃ | Mg(OH)₂, 4MgCO₃,5H₂O | SiO₂ | Eu₂O₃ | MnCO₃ |
|---|---|---|---|---|---|
| 5 | 18,771 | 2,769 | 3,932 | 0,338 | 0,395 |
| 6 | 17,142 | 2,754 | 3,910 | 1,681 | 0,393 |
| 7 | 17,059 | 2,436 | 3,891 | 1,673 | 0,782 |

**Tableau 2**

| Exemple | |
|---|---|
| 5 | Ba_{2,94}EU_{0,06}Mg_{0,9}Mn_{0,1}Si₂O₈ |
| 6 | Ba_{2,70}Eu_{0,30}Mg_{0,9}Mn_{0,1}Si₂O₈ |
| 7 | Ba_{2,70}Eu_{0,30}Mg_{0,8}Mn_{0,2}Si₂O₈ |

Les courbes de la figure 4 donnent, pour les composés ainsi obtenus, le spectre d'émission pour une longueur d'onde d'excitation de 370 nm. On voit que le composé de l'exemple 5 présente pour le bleu et le rouge des intensités d'émission sensiblement analogues. La couleur rouge est par contre maximisée pour le composé de l'exemple 6

## Revendications

1. Diode électroluminescente émettant une lumière blanche, **caractérisée en ce qu'**elle comprend :
- une source d'émission d'une radiation dans la gamme de longueur d'onde comprise entre 370 nm et 420 nm;
- un premier luminophore émettant une lumière bleue et une lumière rouge, de formule :
Ba₃₍₁₋ₓ₎Eu₃ₓMg_{1-y}Mn_{y}Si₂O₈ (1)
dans laquelle 0 < x ≤ 0,3 et 0 < y ≤ 0,3;
- un second luminophore émettant une lumière verte.

2. Diode selon la revendication 1, **caractérisée en ce qu'**elle comprend à titre de second luminophore un luminophore choisi parmi :
- un sulfure de zinc dopé au cuivre ou dopé au cuivre et à l'aluminium;
- un silicate d'alcalino-terreux dopé à l'europium;
- un aluminate d'alcalino-terreux dopé à l'europium;
- un borate de terre rare dopé au cérium et au terbium;
- un thiogallate, thioaluminate ou thioindate de zinc, de magnésium ou d'alcalino-terreux dopé à l'europium et/ou au manganèse;
- un phosphate ou borophosphate d'alcalino-terreux dopé à l'europium ou dopé à l'europium et au terbium;
- un silicate de terre rare dopé à l'europium et au terbium;
- un silicate d'yttrium et d'azote dopé à l'europium;
- un aluminate de magnésium et d'alcalino-terreux dopé à l'europium en combinaison avec le cérium et le terbium ou en combinaison avec du manganèse;
- un chlorosilicate de magnésium et d'alcalino-terreux dopé à l'europium éventuellement en combinaison avec du manganèse.

3. Diode selon la revendication 1, **caractérisée en ce qu'**elle comprend à titre de second luminophore un luminophore choisi parmi Ba₂SiO₄ dopé à l'europium, SrGa₂S₄ dopé à l'europium, le sulfure de zinc dopé au cuivre ou dopé au cuivre et à l'aluminium et SrAl₂O₄ dopé à l'europium, et un composé à base d'au moins un élément A choisi parmi les alcalino-terreux, d'au moins un élément B choisi parmi l'aluminium, le gallium ou l'indium, de soufre et d'un dopant susceptible de conférer des propriétés de luminescence audit composé et qui se présente sous la forme d'un mélange d'une phase cristallographique majoritaire de type AB₂S₄ et d'une phase cristallographique de type B₂S₃.

4. Diode électroluminescente émettant une lumière blanche, **caractérisée en ce qu'**elle comprend :
- une source d'émission d'une radiation dans la gamme de longueur d'onde comprise entre 370 nm et 420 nm;
- un luminophore de composition chimique suivante:
Ba₃₍₁₋ₓ₎Eu₃ₓMg_{1-y}Mn_{y}Si₂O₈
avec 0 < x ≤ 0,3 et 0 < y ≤ 0,3;
ce luminophore se présentant sous la forme d'un mélange d'au moins des phases Ba₂SiO₄, Ba₂MgSi₂O₇ et Ba₃MgSi₂O₈.

5. Diode selon l'une des revendications précédentes, **caractérisée en ce qu'**elle comprend un luminophore de formule (1) ou de composition chimique précitée dans laquelle 0,0001 ≤ x ≤ 0,25 et 0,0001 ≤ y ≤ 0,25.

6. Diode selon la revendication 5, **caractérisée en ce qu'**elle comprend un luminophore de formule (1) ou de composition chimique précitée dans laquelle 0,01 ≤ x ≤ 0,25 et 0,01 ≤ y ≤ 0,25.

7. Diode selon la revendication 6, **caractérisée en ce qu'**elle comprend un luminophore de formule (1) ou de composition chimique précitée dans laquelle 0,01 ≤ x ≤ 0,03 et 0,04 ≤ y ≤ 0,06.

8. Diode selon la revendication 6, **caractérisée en ce qu'**elle comprend un luminophore de formule (1) ou de composition chimique précitée dans laquelle 0,01 ≤ x ≤ 0,02 et 0,05 ≤ y ≤ 0,1.

9. Diode selon la revendication 6, **caractérisée en ce qu'**elle comprend un luminophore de formule (1) ou de composition chimique précitée dans laquelle 0,09 ≤ x ≤ 0,11 et 0,09 ≤ y ≤ 0,11.

10. Diode selon l'une des revendications 1 à 3, **caractérisée en ce qu'**elle comprend un luminophore de formule (1) dans laquelle x = 0,1 et y = 0,1 ou dans laquelle x = 0,1 et y = 0,2.

11. Diode selon l'une des revendications précédentes, **caractérisée en ce qu'**elle comprend un luminophore de formule (1) dans laquelle le baryum, le magnésium et le silicium ne sont pas substitués par d'autres éléments que l'europium et le manganèse.

12. Dispositif d'éclairage, **caractérisé en ce qu'**il comprend une diode selon l'une des revendications précédentes.

## Claims

1. Light-emitting diode that emits white light, **characterized in that** it comprises:
- a source of radiation emission in the wavelength range between 370 nm and 420 nm;
- a first phosphor that emits blue light and red light, of formula:
Ba₃₍₁₋ₓ₎Eu₃ₓMg_{1-y}Mn_{y}Si₂O₈ (1)
in which 0 < x ≤ 0.3 and 0 < y ≤ 0.3; and
- a second phosphor that emits green light.

2. Diode according to Claim 1, **characterized in that** it comprises, as second phosphor, a phosphor chosen from:
- a zinc sulfide doped with copper or doped with copper and aluminum;
- an alkaline-earth silicate doped with europium;
- an alkaline-earth aluminate doped with europium;
- a rare-earth borate doped with cerium and terbium;
- a zinc, magnesium or alkaline-earth thiogallate, thioaluminate or thioindate doped with europium and/or manganese;
- an alkaline-earth phosphate or borophosphate doped with europium or doped with europium and terbium;
- a rare-earth silicate doped with europium and terbium;
- an yttrium/nitrogen silicate doped with europium;
- a magnesium/alkaline-earth aluminate doped with europium in combination with cerium and terbium, or in combination with manganese; and
- a magnesium/alkaline-earth chlorosilicate doped with europium, optionally in combination with manganese.

3. Diode according to Claim 1, **characterized in that** it comprises, as second phosphor, a phosphor chosen from: Ba₂SiO₄ doped with europium; SrGa₂S₄ doped with europium; zinc sulfide doped with copper or doped with copper and aluminum; and SrAl₂O₄ doped with europium; and a compound based on at least one element A chosen from the alkaline earths, on at least one element B chosen from aluminum, gallium or indium, on sulfur and on a dopant capable of giving said compound luminescence properties, which second phosphor is in the form of a mixture of a predominant crystallographic phase of the AB₂S₄ type and of a crystallographic phase of the B₂S₃ type.

4. Light-emitting diode that emits white light, **characterized in that** it comprises:
- a source of radiation emission in the wavelength range between 370 nm and 420 nm;
- a phosphor of the following chemical composition:
Ba_{3 (1-x)} Eu₃ₓMg_{1-y}Mn_{y}Si₂O₈
where 0 < x ≤ 0.3 and 0 < y ≤ 0.3;
this phosphor being in the form of a mixture of at least the phases Ba₂SiO₄, Ba₂MgSi₂O₇ and Ba₃MgSi₂O₈.

5. Diode according to one of the preceding claims, **characterized in that** it comprises a phosphor of formula (1) or of the aforementioned chemical composition in which 0.0001 ≤ x ≤ 0.25 and 0.0001 ≤ y ≤ 0.25.

6. Diode according to Claim 5, **characterized in that** it comprises a phosphor of formula (1) or of the aforementioned chemical composition in which 0.01 ≤ x ≤ 0.25 and 0.01 ≤ y ≤ 0.25.

7. Diode according to Claim 6, **characterized in that** it comprises a phosphor of formula (1) or of the aforementioned chemical composition in which 0.01 ≤ x ≤ 0.03 and 0.04 ≤ y ≤ 0.06.

8. Diode according to Claim 6, **characterized in that** it comprises a phosphor of formula (1) or of the aforementioned chemical composition in which 0.01 ≤ x ≤ 0.02 and 0.05 ≤ y ≤ 0.1.

9. Diode according to Claim 6, **characterized in that** it comprises a phosphor of formula (1) or of the aforementioned chemical composition in which 0.09 ≤ x ≤ 0.11 and 0.09 ≤ y ≤ 0.11.

10. Diode according to one of Claims 1 to 3, **characterized in that** it comprises a phosphor of formula (1) in which x = 0.1 and y = 0.1 or in which x - 0.1 and y = 0.2.

11. Diode according to one of the preceding claims, **characterized in that** it comprises a phosphor of formula (1) in which the barium, the magnesium and the silicon are not substituted with elements other than europium and manganese.

12. Illumination device, **characterized in that** it comprises a diode according to one of the preceding claims.

## Patentansprüche

1. Weißlicht emittierende Lumineszenzdiode, **dadurch gekennzeichnet, daß** sie folgendes umfaßt:
- eine Emissionsquelle einer Strahlung im Wellenlängenbereich zwischen 370 nm und 420 nm;
- einen ersten Leuchtstoff, der Blaulicht und Rotlicht emittiert, der Formel:
Ba₃₍₁₋ₓ₎EU₃ₓMg_{1-y}Mn_{y}Si₂O₈ (1)
worin 0 < x ≤ 0,3 und 0 < y ≤ 0,3; und
- einen zweiten Leuchtstoff, der Grünlicht emittiert.

2. Diode nach Anspruch 1, **dadurch gekennzeichnet, daß** sie als zweiten Leuchtstoff einen unter
- einem mit Kupfer dotierten oder mit Kupfer und Aluminium dotierten Zinksulfid;
- einem mit Europium dotierten Erdalkalimetallsilicat;
- einem mit Europium dotierten Erdalkalimetallaluminat;
- einem mit Cer und Terbium dotierten Seltenerdmetallborat;
- einem mit Europium und/oder Mangan dotierten Zink-, Magnesium- oder Erdalkalimetallthiogallat, -thioaluminat oder -thioindat;
- einem mit Europium dotierten oder mit Europium und Terbium dotierten Erdalkalimetallphosphat oder -borphosphat;
- einem mit Europium und Terbium dotierten Seltenerdmetallsilicat;
- einem mit Europium dotierten Yttriumstickstoffsilicat;
- einem mit Europium in Kombination mit Cer und Terbium oder in Kombination mit Mangan dotierten Magnesiumerdalkalimetallaluminat und
- einem mit Europium, gegebenenfalls in Kombination mit Mangan, dotierten Magnesiumerdalkalimetallchloridsilicat ausgewählten Leuchtstoff umfaßt.

3. Diode nach Anspruch 1, **dadurch gekennzeichnet, daß** sie als zweiten Leuchtstoff einen unter mit Europium dotiertem Ba₂SiO₄, mit Europium dotiertem SrGa₂S₄, mit Kupfer dotiertem oder mit Kupfer und Aluminium dotiertem Zinksulfid und mit Europium dotiertem SrAl₂O₄ und einer Verbindung, die auf mindestens einem Element A, das unter den Erdalkalimetallen ausgewählt ist, mindestens einem Element B, das unter Aluminium, Gallium oder Indium ausgewählt ist, Schwefel und einem Dotierstoff, der der Verbindung Lumineszenzeigenschaften verleihen kann, basiert und in Form einer Mischung einer kristallographischen Hauptphase vom AB₂S₄-Typ und einer kristallographischen Phase vom B₂S₃-Typ vorliegt, ausgewählten Leuchtstoff umfaßt.

4. Weißlicht emittierende Lumineszenzdiode, **dadurch gekennzeichnet, daß** sie folgendes umfaßt:
- eine Emissionsquelle einer Strahlung im Wellenlängenbereich zwischen 370 nm und 420 nm und
- einen Leuchtstoff mit der folgenden chemischen Zusammensetzung:
Ba₃₍₁₋ₓ₎Eu₃ₓMg_{1-y}Mn_{y}Si₂O₈
mit 0 < x ≤ 0,3 und 0 < y ≤ 0,3;
wobei dieser Leuchtstoff in Form einer Mischung mindestens der Phasen Ba₂SiO₄, Ba₂M₉Si₂O₇ and Ba₃M₉Si₂O₈ vorliegt.

5. Diode nach einem der vorhergehenden Ansprüche, **dadurch gekennzeichnet, daß** sie einen Leuchtstoff der Formel (1) bzw. der oben angegebenen chemischen Zusammensetzung, worin 0,0001 ≤ x ≤ 0,25 und 0,0001 ≤ y ≤ 0,25, umfaßt.

6. Diode nach Anspruch 5, **dadurch gekennzeichnet, daß** sie einen Leuchtstoff der Formel (1) bzw. der oben angegebenen chemischen Zusammensetzung, worin 0,01 ≤ x ≤ 0,25 und 0,01 ≤ y ≤ 0,25, umfaßt.

7. Diode nach Anspruch 6, **dadurch gekennzeichnet, daß** sie einen Leuchtstoff der Formel (1) bzw. der oben angegebenen chemischen Zusammensetzung, worin 0,01 ≤ x ≤ 0,03 und 0,04 ≤ y ≤ 0,06, umfaßt.

8. Diode nach Anspruch 6, **dadurch gekennzeichnet, daß** sie einen Leuchtstoff der Formel (1) bzw. der oben angegebenen chemischen Zusammensetzung, worin 0,01 ≤ x ≤ 0,02 und 0,05 ≤ y ≤ 0,1, umfaßt.

9. Diode nach Anspruch 6, **dadurch gekennzeichnet, daß** sie einen Leuchtstoff der Formel (1) bzw. der oben angegebenen chemischen Zusammensetzung, worin 0,09 ≤ x ≤ 0,11 und 0,09 ≤ y ≤ 0,11, umfaßt.

10. Diode nach einem der Ansprüche 1 bis 3, **dadurch gekennzeichnet, daß** sie einen Leuchtstoff der Formel (1), worin x = 0,1 und y = 0,1 oder worin x = 0,1 und y = 0,2, umfaßt.

11. Diode nach einem der vorhergehenden Ansprüche, **dadurch gekennzeichnet, daß** sie einen Leuchtstoff der Formel (1), worin das Barium, das Magnesium und das Silicium nicht durch andere Elemente als Europium und Mangan ersetzt sind, umfaßt.

12. Beleuchtungsvorrichtung, **dadurch gekennzeichnet, daß** sie eine Diode nach einem der vorhergehenden Ansprüche umfaßt.
